# FASCICULE DE BREVET EUROPEEN

(11) **EP 3 169 625 B1**
(45) Date de publication et mention de la délivrance du brevet: **15.04.2020**
(21) Numéro de dépôt: 15742378.1
(22) Date de dépôt: 07.07.2015
(51) Int. Cl.: B81C 1/00

(54) **PROCÉDÉ DE FABRICATION D'UN DISPOSITIF COMPRENANT UN BOÎTIER HERMÉTIQUE SOUS VIDE ET UN GETTER**
VERFAHREN ZUR HERSTELLUNG EINER VORRICHTUNG MIT HERMETISCH ABGEDICHTETEM VAKUUMGEHÄUSE UND GETTER
METHOD FOR MANUFACTURING A DEVICE COMPRISING A HERMETICALLY SEALED VACUUM HOUSING AND GETTER

(30) Priorité: 18.07.2014 FR 1456961
(43) Date de publication de la demande: 24.05.2017
(73) Titulaire: LYNRED, 91120 Palaiseau (FR)
(72) Inventeur: FAVIER, Jérôme, 38380 Saint Laurent du Pont (FR); BUNEL, David, 38430 Moirans (FR)
(74) Mandataire: Cabinet Laurent & Charras
(86) Numéro de dépôt international: PCT/FR2015/051869
(87) Numéro de publication internationale: WO 2016/009126

(56) Documents cités:
- EP-A1- 1 640 333
- EP-A2- 2 586 741
- US-A1- 2013 214 400

## Description

### DOMAINE DE L'INVENTION

L'invention a trait au domaine du scellement hermétique de composants micro-électroniques sous vide poussé, par exemple les détecteurs à base de microbolomètres pour l'imagerie infrarouge ou la thermométrie.

### ETAT DE LA TECHNIQUE

Pour certaines applications, des composants micro-électroniques doivent fonctionner sous vide pour atteindre les performances requises. C'est notamment le cas des détecteurs non refroidis pour l'imagerie infrarouge à base de micro-ponts bolométriques, ci-après dénommés « microbolomètres ». Dans le domaine des détecteurs infrarouges dits « thermiques », il est en effet connu d'utiliser des matrices monodimensionnelles ou bidimensionnelles d'éléments sensibles au rayonnement infrarouge, susceptibles de fonctionner à température ambiante.

Un détecteur infrarouge thermique utilise traditionnellement la variation de la résistivité électrique d'un matériau thermométrique, ou également connu sous le nom de « bolométrique », en fonction de sa température. Les éléments sensibles unitaires du détecteur, ou « bolomètres », prennent usuellement la forme de membranes, comprenant chacune une couche en matériau thermométrique, suspendues au-dessus d'un substrat, généralement réalisé en silicium, par des bras de soutien de résistance thermique élevée. Ces membranes, collectivement désignées sous le terme de « rétine », mettent notamment en œuvre une fonction d'absorption du rayonnement infrarouge incident, une fonction de conversion de la puissance du rayonnement absorbé en puissance calorifique, et une fonction thermométrique de conversion de la puissance calorifique produite en une variation de la résistivité du matériau thermométrique, ces fonctions pouvant être mises en œuvre par un ou plusieurs éléments distincts. Par ailleurs, les bras de soutien des membranes sont également électriquement conducteurs et connectés à la couche thermométrique de celles-ci, et il est usuellement ménagé dans le substrat au-dessus duquel sont suspendues les membranes, des moyens d'adressage et de polarisation séquentiels des éléments thermométriques des membranes, et des moyens de formation des signaux électriques utilisables en formats vidéo.

Un tel détecteur est par exemple décrit dans le document : « Uncooled amorphous silicon technology enhancement for 25µm pixel pitch achievement » ; E. Mottin et al, Infrared Technology and Application XXVIII, SPIE, vol. 4820E.

Afin de rendre négligeables les pertes thermiques par convection gazeuse qui limiteraient la qualité de la détection, la rétine sensible est habituellement intégrée dans un boitier, ou enceinte, hermétique sous très faible pression. Le boitier est muni d'une fenêtre transparente aux rayonnements d'intérêt, usuellement entre 8 et 14 micromètres de longueur d'onde. Alternativement, chaque bolomètre est intégré dans un micro-boitier hermétique muni d'une telle fenêtre. Le niveau de pression dans le boitier est typiquement ajusté pour que les pertes par convection soient inférieures aux pertes par conduction thermique via les bras de soutien, assurant ainsi une détection de qualité. Pour ce faire, la pression des gaz dans le boitier est donc usuellement inférieure ou égale à 10⁻² mbar, et de préférence inférieure à 10⁻⁴ mbar.

Toutefois, l'obtention d'un tel niveau de pression nécessite des techniques particulières lors du scellement hermétique du boitier. En outre, on observe que certains matériaux dégazent après scellement dans le volume interne, ou cavité, délimité par le boitier. Il convient donc également de garantir le maintien du bas niveau initial de pression dans le boitier tout au long de la durée de vie du détecteur, typiquement 20 ans, malgré le dégazage des surfaces et éléments internes au boitier.

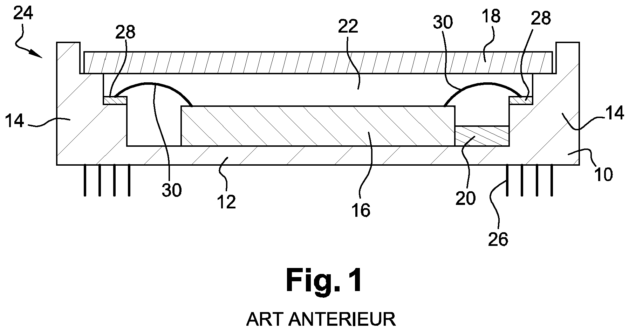

En se référant à l'exemple de la figure 1, le scellement sous vide d'un dispositif de détection bolométrique met usuellement en œuvre les sous-ensembles suivants : une embase **10** comprenant un fond **12** et des parois latérales **14,** réalisés en un seul tenant, le détecteur bolométrique **16,** constitué habituellement de la rétine sensible intégrée sur le substrat de lecture, et un capot transparent au rayonnement infrarouge **18,** ou « fenêtre », jouant à la fois un rôle de protection mécanique, de fermeture hermétique de l'embase **10** et de transparence au rayonnement infrarouge. Enfin, un piège à gaz **20,** ou « getter », est également logé dans le boitier pour maintenir un niveau de vide suffisant malgré le dégazage des éléments en communication avec le volume interne **22** du boitier **24** défini par l'embase **10** et la fenêtre **18.**

L'embase **10** est usuellement composée d'un assemblage de matériaux à dominante métallique ou céramique, et réalise également l'interface électrique du détecteur avec l'extérieur du boitier au moyen d'une connectique **26.** Le composant **16** est fixé au fond du boitier, par exemple par collage, puis relié à des plages de connexion **28** réservées à cet effet dans le boitier **24** par un câblage filaire **30** connu en soi de l'état de la technique.

La fenêtre **18** est assemblée sur l'embase **10** directement, ou indirectement au moyen d'une pièce intermédiaire, l'assemblage étant réalisé par un brasage sans flux dont les conditions opératoires limitent le dégazage des sous-ensembles venant d'être décrits lors du scellement de la fenêtre sur l'embase. Comme cela est connu en soi, le brasage sans flux nécessite la présence de couches métalliques non oxydées sur la fenêtre **18** et l'embase **10,** au niveau de surfaces destinées à la jonction hermétique de ces pièces. Les couches métalliques sont donc usuellement constituées d'une ou plusieurs couches dont la dernière au moins est constituée d'un métal noble tel que l'or ou plus rarement le platine. Le brasage sans flux, qui permet de solidariser des éléments métalliques entre eux par diffusion atomique au moyen d'une action mécanique, ou plus habituellement par chauffage jusqu'à fusion au moins partielle du joint métallique, est bien connu en soi et ne sera donc pas décrit en détail. Comme cela est connu en soi, pour obtenir une bonne connexion entre d'éléments métalliques, e.g. par soudure ou brasage, il est préférable que ces éléments ne soient pas oxydés en surface. Pour ce faire, soit il est utilisé un matériau désoxydant, ou flux, afin de faire disparaître la couche d'oxyde, ou bien les éléments métalliques sont non oxydables.

Le getter **20** est quant à lui usuellement constitué de matériaux à forte affinité avec les molécules gazeuses principales susceptibles d'être émises (dégazées) par toutes les surfaces internes de la cavité **22** du boitier. Notamment, le getter est choisi pour adsorber du H₂, du N₂, de l'O₂, du H₂O, et des composés volatils carbonés (dits organiques) comme par exemple CH₄. Les matériaux typiques utilisés pour le getter sont de manière bien connue des alliages ayant pour base les éléments Zr, Ti, Co, Fe, ou Ba. Le getter **20** se présente usuellement soit sous la forme de blocs frittés, et fixés à l'intérieur de la cavité **22,** soit sous forme d'une ou plusieurs couches minces déposées sur des lames, des plaquettes ou des substrats minéraux au moyen de techniques d'évaporation ou de pulvérisation cathodique (« *sputtering* »), intégrés dans la cavité **22** lors de l'assemblage du composant **16** dans le boitier **24.**

Comme cela est connu en soi, un getter utilisé dans ce type d'application nécessite d'être activé pour pouvoir adsorber les gaz précédemment indiqués, l'activation consistant en une mise en condition réactive de la surface du getter au moyen d'un cycle thermique adapté pratiqué sous vide. Un getter **20** sous forme de couches minces, d'une épaisseur de l'ordre de un à quelques micromètres nécessite généralement un cycle thermique d'activation à bien moins haute température qu'un getter fritté. Ainsi, les getters connus en couches minces sont activables par simple chauffage du dispositif venant d'être décrit à une température comprise entre 350°C et 400°C une fois le boitier scellé.

Les getters frittés nécessitent quant à eux une température de l'ordre de 800°C ou plus, de sorte qu'un chauffage global du boitier hermétique à cette température provoquerait des dommages irréparables. L'activation d'un getter fritté est donc réalisée par effet Joule au moyen de connexions électriques prévues dans ce but, ce qui permet de chauffer sensiblement uniquement le getter. L'activation d'un tel getter induit cependant un rayonnement intense susceptible d'endommager les bolomètres. En outre, un getter en couches minces est usuellement préféré car il ne nécessite aucune connexion électrique accessible depuis l'extérieur du boitier. Ce caractère simplifie l'architecture, donc le processus de fabrication, et réduit ainsi le cout du boitier. En effet, les connexions traversant l'embase du boitier peuvent poser des problèmes d'herméticité et induire des contraintes notoires de conception du fait des intensités importantes à appliquer lors de l'activation pour produire les hautes températures nécessaires.

Toutefois, un getter à couches minces contraint le procédé global de fabrication du dispositif, car l'efficacité du getter est d'autant meilleure que la température d'activation est élevée, bien que dans une gamme plus basse comme précisé. De fait, c'est toujours cette étape particulière d'activation thermique, réalisée de manière globale sur l'ensemble du dispositif, qui définit le point maximal de température auquel est soumis le composant électronique au cours de son cycle de fabrication. En d'autres termes, la conception complète du composant, et d'une manière générale toutes les parties du dispositif, sont de fait directement dépendants des caractéristiques du getter à couches minces utilisé. Le document EP 1 640 333 A1 divulgue un dispositif comprenant un composant microélectronique et un boitier, le composant microélectronique étant logé dans le boitier. Ledit boitier est formé de parois délimitant un volume interne hermétique sous vide et un piège à gaz est logé dans le volume interne. EP 1 640 333 A1 divulgue entre autres des couches minces en Pt ou en Pd qui piègent uniquement de l'hydrogène et sont inertes vis-à-vis de l'oxygène et de l'azote. Le procédé de fabrication dudit dispositif comporte la réalisation dudit piège à gaz sous forme de couches minces, le pompage dudit volume interne et, après ledit pompage, le scellement hermétique du boitier. Le scellement du boitier est réalisé à une température inférieure à 300 °C.

### EXPOSE DE L'INVENTION

Le but de la présente invention est de résoudre le problème susmentionnée de chauffage excessif en proposant un procédé de fabrication d'un dispositif comprenant un composant micro électronique logé dans un boitier hermétique dans lequel une pression basse est maintenue à l'aide d'un getter qui ne nécessite pas de traitement thermique contraignant.

A cet effet, l'invention a pour objet un procédé de fabrication d'un dispositif comprenant un composant microélectronique logé dans un boitier formé de parois délimitant un volume interne hermétique sous vide, comprenant :
- la réalisation d'un piège à gaz sous forme de couches minces apte à piéger du gaz dans ledit volume interne ;
- le pompage dudit volume interne ;
- pendant ledit pompage, le chauffage du dispositif de manière à dégazer des éléments logés dans ledit volume interne ; et
- après ledit pompage, le scellement hermétique du boitier sans utiliser de flux.

Selon l'invention :
- chaque matériau constitutif du dispositif susceptible de dégazer dans le volume interne est un matériau minéral ;
- le piège à gaz est apte à piéger sensiblement uniquement de l'hydrogène et est inerte vis-à-vis de l'oxygène et/ou de l'azote ; et
- le chauffage du dispositif et le scellement du boitier sont réalisés à une température inférieure à 300 °C, notamment une température comprise entre 100°C et 200°C.

Par « couche mince », on entend un élément formé d'une ou plusieurs couches d'épaisseur totale inférieure à 2 micromètres, dont chaque couche a de préférence une épaisseur comprise entre 0,1 et 1 micromètre.

Par matériau « minéral », on entend un matériau métallique, céramique ou semiconducteur inorganique ou toute combinaison, assemblage, alliage, dispersion desdits matériaux entre eux, de préférence selon une forme non poreuse. Dans ce contexte, tous les matériaux relevant de la chimie organique, c'est-à-dire à base de carbone, sont considérés comme non minéraux, à l'exception précisément des formes du carbone pur ou allié, combiné ou non, dispersé ou non avec ou dans un autre matériau minéral. En particulier, les polymères carbonés contenant ou non des solvants organiques à la base des adhésifs sont considérés comme des matériaux non minéraux.

En d'autres termes, il est usuellement considéré que dans le cas des composants scellés sous vide poussé, les gaz qui doivent être adsorbés par le getter durant le cycle de vie des composants sont majoritairement de l'azote, de l'hydrogène, de la vapeur d'eau, et dans une moindre mesure des composés carbonés, notamment du CO, du CO₂ et du CH₄. La présence de ces gaz réputée systématique en plus ou moins grande quantité nécessite l'utilisation de matériaux de piégeage des gaz, ou « getter », suffisamment réactifs à l'ensemble de ceux-ci. C'est pourquoi, les matériaux getter sont usuellement constitués ou contiennent du zirconium ou du titane, ces derniers étant capables de piéger une grande variété de gaz.

Or, ces métaux sont naturellement « passivés » en surface, c'est-à-dire recouverts d'une couche peu perméable et/ou peu réactive, notamment une couche d'oxyde ou de nitrure. Cette passivation par l'oxygène ou l'azote est en pratique inévitable après l'élaboration du getter, du fait de sa fabrication séparée préalable à l'intégration finale dans le boitier. Il en résulte qu'une réactivation *in situ* de la surface du getter est nécessaire pour éliminer cette couche superficielle et rendre ainsi actif le getter, l'activation étant obtenue sous vide poussé et à des températures supérieures à 300°C.

Toutefois, les inventeurs ont constaté que les pressions partielles dans le boitier hermétique des gaz autres que l'hydrogène peuvent être maîtrisées et contrôlées lors du scellement et durant le cycle de vie du dispositif grâce à des techniques et précautions particulières de conception et d'assemblage. En pratique, les matériaux minéraux ont généralement un taux de dégazage des gaz autres que l'hydrogène suffisamment faible, après chauffage sous vide poussé, pour être négligé dans les gammes de pressions considérées dans le contexte de l'invention.

Plus particulièrement, la somme des pressions partielles hors hydrogène obtenue par les inventeurs, et ce de manière reproductible sur plusieurs dispositifs, dans les boîtiers scellés sous vide poussé est de l'ordre de 10⁻⁵ mbar et n'évolue que de manière négligeable au cours du temps après le scellement du boitier. En revanche, les inventeurs ont noté que la pression partielle d'hydrogène est très fluctuante et susceptible d'évoluer au cours du temps une fois le boitier scellé hermétiquement. Les inventeurs ont ainsi constaté que, contrairement à l'état de la technique du scellement sous vide des boitiers, l'utilisation d'un getter uniquement réactif à l'hydrogène permet d'atteindre le niveau et la stabilité en pression requis, typiquement de l'ordre de 10⁻⁴ mbar, en prenant des précautions particulières simples.

Ces précautions particulières consistent notamment, à employer uniquement pour toutes les surfaces en relation avec la cavité des matériaux qui ne dégazent sensiblement aucun gaz autre, le cas échéant, que l'hydrogène une fois le boitier scellé, et à mettre en œuvre une étape de dégazage par un chauffage modéré du dispositif avant le scellement du boitier pour libérer les surfaces internes de la cavité d'éventuelles contaminations telles que O₂, H₂O, N₂, Ar et la plupart des molécules volatiles de nature ou origine organique, c'est-à-dire contenant du carbone chimiquement lié avec de l'hydrogène, de l'azote, de l'oxygène, par exemple CO, CO₂, les hydrocarbures (e.g. : CH₄), ou un halogène tel du fluor ou du chlore par exemple. De manière caractéristique, tous les matériaux susceptibles de dégazer dans la cavité interne, sont des matériaux minéraux, de préférence non poreux, et s'ils comprennent du carbone, ce dernier est sous une ou plusieurs de ses formes solides.

De cette manière, il est assuré une quantité très faible de gaz atmosphériques et organiques dans le boitier hermétique et la source principale d'instabilité de la pression dans ce dernier est inhibée par un getter uniquement à hydrogène. Or, les inventeurs ont également constaté qu'en étant bien moins contraint sur le type de gaz devant être piégé, il est possible d'utiliser des matériaux de piégeage qui ne se passivent pas en surface, autrement dit qui ne forment pas une couche d'oxyde et/ou de nitrure à leur surface, notamment du palladium. L'absence de passivation par l'oxygène et/ou l'azote (e.g. l'oxygène et l'azote gazeux présents dans l'atmosphère), notamment sous les conditions de pression et de température rencontrées pendant la fabrication du boitier (précisément, une pression comprise entre 10⁻⁵ bars et 1,5 bar et une température comprise entre 0°C et 300°C) évite la nécessité d'activation par chauffage. Comme le dispositif n'a plus besoin d'être soumis à des températures supérieures à 300°C, ses éléments les plus sensibles, notamment le composant microélectronique et sa rétine bolométrique, sont nettement moins susceptibles de dégradation thermique de leurs propriétés, point déterminant pour la mise en œuvre de structures ou matériaux fragiles ou/et thermiquement instables.

Le scellement sans flux peut par exemple être réalisé au moyen d'une brasure sans flux, d'une liaison anodique, d'une liaison par diffusion métallique, ou d'une liaison par adhésion moléculaire.

Selon un mode de réalisation :
- la réalisation du boitier hermétique comporte la réalisation de parois inférieures et d'un capot supérieur (en particulier une fenêtre transparente aux infrarouges dans le cadre d'un détecteur infrarouge);
- la réalisation du piège à gaz comporte la réalisation d'une couche métallique de matériau de piégeage de l'hydrogène sur le capot ;
- le report du capot sur les parois inférieures avec une première partie uniquement de ladite couche de piégeage reposant sur les parois inférieures ;
- la réalisation du piège à gaz avec au moins une seconde partie de ladite couche de piégeage ne reposant pas sur les parois inférieures ; et
- l'application d'une action mécanique de contact, c'est-à-dire un effort de compression ou/et de friction entre les parois inférieures et le capot, et/ou un chauffage de ladite première partie de couche de piégeage de manière à former sans apport de flux un joint métallique hermétique, autrement dit le scellement, à pratiquer sans flux, entre le capot et les parois inférieures.

Plus particulièrement, la première partie et la seconde partie de ladite couche de piégeage forment un unique motif continu, ou plusieurs motifs discontinus, c'est à dire selon au moins deux parties séparées. Autrement formulé, ces au moins deux parties sont connexes ou disjointes.

En d'autres termes, le getter à hydrogène est formé ou comprend une couche métallique déposée sur au moins une des parois du boitier hermétique et au moins partiellement exposée à l'atmosphère interne du boitier. Plus particulièrement, cette couche est formée sur la fenêtre du boitier. En variante, le capot comporte des parois prenant appui sur un substrat, typiquement le substrat sur lequel est réalisé le composant microélectronique, le capot ayant une section en forme de U par exemple, et la couche métallique est formée sur le substrat. Cette couche comporte avantageusement deux parties formées en une seule opération, une première partie étant intégrée dans la jonction d'assemblage par brasage sans flux du boitier, et une seconde partie étant en interaction directe avec l'intérieur du boitier et entrant par conséquent dans la constitution du getter. Le procédé de brasage est mis en œuvre sans flux lors de la réalisation de l'assemblage selon l'invention afin d'éviter la présence dans la cavité, même à l'état de traces, d'un ou plusieurs constituants du flux de brasure qui ne permettrait pas d'atteindre le niveau de vide visé. Cette couche peut avantageusement servir de matériau d'interface de brasure sans flux pour sceller le boitier. Ainsi, la formation d'une partie au moins du getter hydrogène nécessaire à la qualité du vide final, et d'une partie au moins du joint d'assemblage hermétique au moyen d'une unique étape de fabrication permet de simplifier la conception du dispositif et de limiter le coût de fabrication de ce dernier, notamment le coût de fabrication de la fenêtre. Plus particulièrement, selon l'état de la technique, la métallisation des fenêtres avec des métaux nobles pour le brasage sans flux d'une part, et la fonction getter d'autre part, sont obtenues de manière indépendante au moyen de couches séparées en raison notamment des matériaux différents mis en jeu. Le mode de réalisation de l'invention réduit le nombre d'étapes de fabrication, d'où une réduction du coût de fabrication.

Selon un mode de réalisation, le piège à gaz comporte un matériau de piégeage de l'hydrogène constitué de palladium ou de platine, ou d'un mélange ou d'un alliage de ceux-ci. Le palladium ou le platine permettent de former simultanément un piège à hydrogène, et une surface insensible à la passivation, notamment par l'oxygène et par l'azote, adaptée à la mise en œuvre d'une brasure sans flux.

Selon un mode de réalisation, le piège à gaz comprend une couche de palladium ou de platine d'une épaisseur comprise entre 100 nanomètres et 1 micromètre.

Selon un mode de réalisation, la pression de gaz dans le volume interne est inférieure à 10⁻⁴ mbar, et le composant électronique est un détecteur bolométrique.

L'invention a également pour objectif un dispositif comprenant un composant microélectronique et un boitier, le composant microélectronique étant logé dans le boitier, obtenu selon le procédé de l'une quelconques des revendications 1 à 6, dans lequel :
- le boitier est formé de parois délimitant un volume interne hermétique sous vide,
- le dispositif est constitué de matériaux susceptibles de dégazer dans ledit volume interne, lesdits matériaux étant des matériaux métalliques, céramiques ou semi-conducteurs inorganiques, ou du carbone, ou toute combinaison, assemblage, alliage, dispersion desdits matériaux entre eux ;
- un piège à gaz est logé dans le volume interne, et piège uniquement de l'hydrogène et est inerte vis-à-vis de l'oxygène et/ou de l'azote.

Selon un mode de réalisation, le boitier comprend une fenêtre scellée hermétiquement sur une embase au moyen d'une couche métallique de scellement, et le piège à gaz comprend une couche de matériau de piégeage métallique, selon une disposition où la couche de scellement et la couche de matériau de piégeage sont constituées d'une même et unique couche de matériau métallique. Notamment, la couche métallique de scellement et la couche de matériau métallique de piégeage sont connexes.

### BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :
- la figure 1 est une vue schématique en coupe d'un dispositif de détection bolométrique de l'état de la technique, déjà décrit ci-dessus ;
- la figure 2 est une vue schématique de la face en regard du volume interne d'une fenêtre de boitier de détecteur bolométrique selon l'invention ; et
- la figure 3 est une vue schématique en coupe d'un dispositif comportant un composant encapsulé dans un micro-boitier.

### DESCRIPTION DETAILLEE DE L'INVENTION

Dans ce qui suit des exemples de procédé de fabrication d'un boitier hermétique comportant un composant microélectronique et un piège à hydrogène sont décrits. Ces exemples se fondent sur des procédés bien connus de l'état de la technique, modifiés pour mettre en œuvre l'invention.

### A) PREMIER EXEMPLE DE RÉALISATION : SCELLEMENT DU BOITIER AVEC MISE SOUS VIDE DU BOITIER PAR L'INTERMEDIAIRE D'UN QUEUSOT DE POMPAGE

Selon un procédé de l'état de la technique, les boîtiers hermétiquement fermés par une fenêtre transparente aux rayonnements d'intérêt, usuellement réalisée en silicium ou en germanium pour les applications infrarouges, sont mis sous vide par l'intermédiaire d'un tube traversant une paroi du boitier, dit « queusot », permettant le pompage du volume interne du boitier. Le boitier est typiquement formé de matériaux métalliques ou associant un métal pour les parois, le fond et le capot, et du verre et/ou de la céramique pour les passages électriques formés dans les parois, formant ainsi une enceinte fermée hermétique une fois le queusot scellé mécaniquement. Plus particulièrement, la fenêtre est reportée sur les parois latérales du boitier et solidarisée à celles-ci par brasage. Une couche de matériau de brasure métallique est à cet effet déposée sur la fenêtre et/ou les parois latérales du boitier puis une action thermique et/ou mécanique est exercée pour obtenir la diffusion / migration atomique ou/et la fusion au moins partielle du matériau de brasure et ainsi obtenir la jointure hermétique de la fenêtre et des parois latérales.

Afin d'atteindre le niveau de vide désiré, l'ensemble est ensuite chauffé à des températures de l'ordre de 100 °C à 200 °C pour dégazer les surfaces internes au boitier tout en réalisant un pompage dynamique dudit volume au travers du queusot. Cette étape de pompage dure usuellement entre plusieurs heures et quelques jours en fonction du niveau de vide souhaité, des dimensions du boîtier et du queusot, et de la présence dans le boîtier d'éléments chargés ou sources de gaz divers, par exemple des composés de nature organique, tels des adhésifs ou des polymères. En fin d'étape de pompage, le queusot, habituellement en cuivre, est écrasé et sectionné à l'aide d'une pince hydraulique. Cette étape est communément appelée « queusotage » (ou « *pinch off* »). L'activation du getter disposé à l'intérieur du boitier scellé est pratiquée ultérieurement lors d'une étape additionnelle. Selon cet état de la technique, le getter est usuellement un getter fritté qui nécessite une activation à haute température, typiquement 800°C au moins, de manière électrique par effet Joule afin de ne chauffer que le getter lui-même.

Selon l'invention, le getter fritté est remplacé par un getter uniquement à hydrogène ne nécessitant pas d'activation, déposé sur un des constituants de l'enceinte hermétique, par exemple sur l'embase, l'une des parois latérale du boitier, ou sur la face de la fenêtre en relation avec le volume interne, ou encore sur une partie de la fenêtre ne gênant pas la détection d'une rétine bolométrique disposée dans le boitier. Le getter comprend en tant que matériau de piégeage des gaz une couche de métal noble apte à absorber de l'hydrogène par physisorption, d'une épaisseur comprise entre 100 nanomètres et 1 micromètre. Cette couche est par exemple déposée sur une lame métallique, ou « lame getter », préalablement brasée ou soudée par points sur une plage métallisée à l'intérieur du boitier selon des techniques connues. Il n'est nul besoin selon l'invention de protéger la partie destinée à l'assemblage brasé ou soudé de la lame getter lors du dépôt du matériau de piégeage des gaz sur la lame, car ce dernier ne se passive pas une fois déposé. La séquence de fabrication de la lame est donc simplifiée et moins onéreuse.

De manière avantageuse, le matériau de piégeage de l'hydrogène est également choisi pour présenter des qualités nécessaires pour la mise en œuvre ultérieure d'un brasage sans flux, ce qui est notamment le cas du palladium qui est un métal noble. Ce faisant, ce matériau est également utilisé pour le scellement de la fenêtre, ce qui permet de réduire le nombre d'étapes de fabrication. Plus particulièrement, la couche de matériau de brasure et la couche de matériau de piégeage de l'hydrogène sont réalisées sur la fenêtre, en dehors de la zone réservée de transparence optique, en une seule et même étape de dépôt, l'épaisseur de la couche pour le brasage pouvant ou non être différente de l'épaisseur de la couche pour le getter. Ledit dépôt comporte ainsi selon cette variante :
- une première partie, préférentiellement en extrême périphérie de la fenêtre, destinée au brasage sans flux de ladite fenêtre sur les parois latérales du boitier, avec le cas échéant un support intermédiaire si nécessaire comme cela est connu ; et
- une seconde partie connexe ou disjointe de la première partie, préférentiellement en périphérie intérieure de la fenêtre, laquelle restera en relation directe avec le volume interne du boitier une fois la fenêtre scellée, et destinée à jouer le rôle de getter.

Avantageusement, il est réalisé un empilement d'au moins deux couches pour augmenter la tenue mécanique du getter et/ou du matériau de brasure. Le dépôt comprend notamment le dépôt d'au moins une première couche d'accroche dont la fonction est d'améliorer la cohésion mécanique entre ledit empilement métallique et la surface sur laquelle l'empilement est réalisé, suivi du dépôt d'au moins une seconde couche constituant le matériau de piégeage de l'hydrogène. Ainsi sur ladite surface, qui correspond à la lame getter ou la fenêtre selon les modes exposés précédemment, il est déposé une première couche d'accroche de titane ou de chrome, puis une seconde couche de matériau de piégeage/brasure est déposée sur la couche d'accroche. Les épaisseurs de matériaux déposés sont de l'ordre de 30 nm à 300 nm pour la couche d'accroche (typiquement titane ou chrome) et de 100 nm à 1 µm pour le matériau de piégeage/brasure (notamment palladium ou platine).

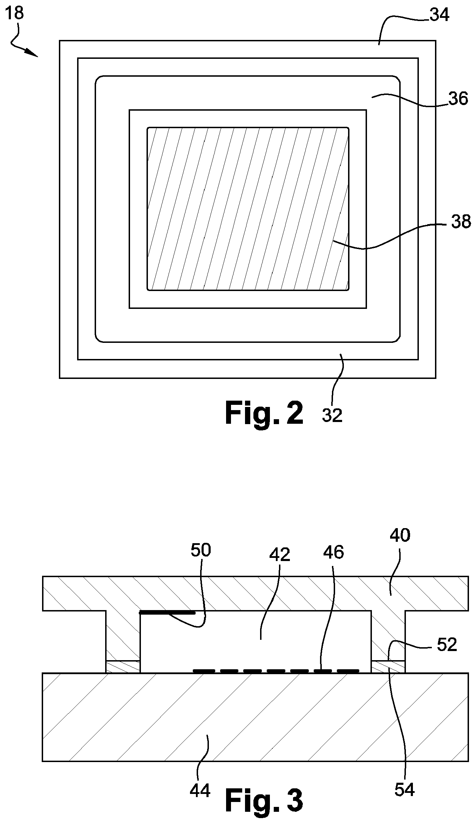

En se référant à la vue de la face en regard de la cavité interne de la fenêtre de la figure 2, la surface **32** de la fenêtre **18** reportée sur les parois internes du boitier comprend une zone de métallisation **34** réalisée sur le bord de la fenêtre, à savoir la portion de fenêtre reportée et scellée sur les parois latérales du boitier, et une zone de getter à hydrogène **36** réalisée en dehors de ladite portion, par exemple sous la forme d'une bande, les zones **34** et **36** étant déposées lors d'une même étape de dépôt sur la surface **32.** Ce dépôt peut être avantageusement, mais pas nécessairement, mis en œuvre au cours de la fabrication collective d'une pluralité de fenêtres, c'est-à-dire avant la « *singulation* », ou découpe, en éléments unitaires à partir d'un substrat fenêtre de plus grande surface, typiquement de format microélectronique standard (disques de 100, 150, 200 mm de diamètre ou plus). Avantageusement, la portion centrale **38** destinée à transmettre le rayonnement infrarouge aux éléments de détection internes au boitier est protégée par masquage lors du dépôt des zones métalliques **34, 36.** Avantageusement, pour éviter les opérations de gravure de l'empilement métallique, les diverses parties de cette couche sont définies ensemble par exemple selon la technique dite de « *lift-off* » ou de pochoir mécanique (« *shadow mask* »).

De fait, les composants assemblés de cette manière présentent les caractères requis de qualité initiale et stabilité du vide après l'étape traditionnelle de pompage - dégazage à travers le queusot, telle que décrite précédemment.

De préférence, le matériau de piégeage/brasure est du palladium. Ce métal noble présente en effet :
- les caractéristiques chimiques d'absorption par physisorption de l'hydrogène. Ce métal peut en effet d'absorber une grande quantité d'hydrogène, comme le montre le document Vacuum properties of palladium thin film coatings, C. Benvenuti et al., Vacuum 73 (2004) 139-144] ; et
- les caractéristiques chimiques adéquates au brasage sans flux car il s'agit d'un métal non oxydable et non nitrurable au contact de l'atmosphère, en d'autres termes, qui ne se passive pas au contact de l'oxygène et de l'azote présents dans l'atmosphère.

Le getter hydrogène proposé dans l'invention possède la propriété particulière de ne pas nécessiter d'activation, car le palladium ne se passive pas par oxydation ou nitruration de surface lorsqu'il est exposé à l'atmosphère. Le pompage de l'hydrogène par physisorption est actif à tout moment, et réversible. L'étape de dégazage sous vide avant queusotage permet en outre de dégazer l'hydrogène capté par ce métal durant son séjour à l'atmosphère. Ainsi, le procédé selon l'invention est efficace pour maintenir une basse pression d'hydrogène dans boitier sous vide sans nécessiter d'activation thermique à haute température ou d'activation électrique caractéristiques des getters usuellement mis en œuvre.

Pour obtenir le niveau de vide requis inférieur à 10⁻² mbar, et de préférence inférieur à 10⁻⁴ mbar, la cavité formée par le boitier ne contient pas de constituants de nature ou origine organiques, par exemple des polymères ou adhésifs, qui dégazent toujours et très durablement de grandes quantités, par rapport au niveau de vide requis, de vapeur d'eau et de composés volatils carbonés. Le composant électronique, ou puce, logé dans le boitier, à savoir le circuit intégré portant les structures sensibles de détection et ces structures elles-mêmes, par exemple microbolométriques, est fixé avantageusement par brasage sans flux au moyen de métaux. Les matériaux constitutifs préférentiels de tous les éléments susceptibles de dégazer dans le boitier sont donc inorganiques notamment de nature minérale préférentiellement non poreuse, tels typiquement et de manière connue et non limitative les semi-conducteurs minéraux (Si, Ge, etc.), les métaux, les céramiques denses telles l'alumine (Al₂O₃) ou le nitrure d'aluminium (AlN), ou encore les diverses formes du carbone, pur ou chimiquement combiné par exemple sous forme de carbures, ainsi que toutes les associations, assemblages, alliages, dispersions de ces matériaux entre eux en toutes proportions.

### B) SECOND EXEMPLE DE RÉALISATION : SCELLEMENT DU BOITIER AVEC MISE SOUS VIDE DU BOITIER SELON UNE METHODE DE SCELLEMENT COLLECTIF DE PIECES UNITAIRES

Un autre état de la technique concernant le scellement hermétique de composants microélectroniques, en particulier de composants d'imagerie microbolométrique, propose un scellement collectif qui ne fait pas appel à des tubes queusot pour obtenir le vide dans la cavité d'un boitier. Selon par exemple le document FR 2 874 691, il est possible de réaliser l'assemblage de composants discrets collectivement dans un four sous vide porté à une température suffisante pendant une durée adaptée au niveau de vide requis.

Comme dans le cas des boitiers à pompage par tube queusot selon l'invention, les cavités sous vide ne contiennent sensiblement aucun matériau organique (polymères, adhésifs) qui dégazent de manière excessive et trop durable pour la mise en œuvre de l'invention.

Le composant microélectronique est notamment fixé par brasage sans flux, dans le boitier en regard de la fenêtre transparente aux infrarouges. Les matériaux constitutifs préférentiels dans le cadre d'un scellement collectif sont semblables au mode de réalisation précédemment décrit, en termes de getter et/ou de scellement par brasage de la fenêtre. Notamment, le getter est déposé en couche mince sur une paroi de la cavité. Le boîtier utilisé dans le cadre de l'invention ne nécessite quant à lui aucune technologie spécifique autre que celles de l'état de la technique du scellement de boîtier hermétique sous vide dit secondaire.

Typiquement, le boitier sera donc métallique ou céramique et comprend des plages métallisées pour recevoir le brasage, par report du composant électronique, puis de la fenêtre, recouvertes d'une couche de métal noble tel que l'or, afin de permettre la mise en œuvre d'une brasure sans flux pour l'assemblage du composant puis de la fenêtre.

Le composant comporte sur la face fixée au boitier une couche de métal noble qui est brasée sans flux à l'intérieur du boîtier selon un cycle thermique préférentiellement séparé du cycle de dégazage et scellement du boitier, ce qui permet notamment de former avant scellement les connexions filaires entre le composant et les traversées électriques du boitier.

Le matériau de brasure servant aux assemblages est préférentiellement apporté sous forme de préforme métallique, de composition définie par la température de fusion souhaitée, et de forme géométrique adaptée au besoin de l'assemblage. Ainsi par exemple, le composant peut être fixé au boitier au moyen d'une brasure classique de type Au 80% - Sn 20% en masse, dont la température de fusion de 280 °C est compatible avec le choix d'une seconde préforme classique de type SAC 305 (alliage étain-argent-cuivre) fusible à environ 240 °C pour la brasure du joint de scellement entre la fenêtre et l'embase du boitier selon l'invention. L'épaisseur de ces préformes est par ailleurs choisie suffisante pour compenser les défauts de planéité de ces sous-ensembles mis en vis-à-vis. Une épaisseur de préforme entre 20 et 150µm est notamment choisie à cet effet.

La fenêtre utilisée est typiquement de fabrication identique à celle proposée dans le cadre de la première forme de réalisation avec tube queusot, c'est-à-dire de manière unitaire, mais avantageusement fabriquée de manière collective, à partir de substrats de grand format découpés en fenêtres unitaires après formation des fonctions localisées de traitements optiques sur les surfaces destinées à être transparentes au rayonnement, et du getter sur au moins une partie des surfaces destinées à rester opaques.

Le dégazage et le scellement se font alors dans le même cycle thermique sous vide poussé pour atteindre la pression finale requise dans le composant. Les différents éléments du boitier, et notamment la fenêtre, sont de préférence pré-dégazés préalablement au scellement de la fenêtre dans un four sous vide poussé, par exemple selon les méthodes décrites dans le document FR 0409055. Toutefois, il n'est ici pas utile selon l'invention de dégazer / activer l'élément qui porte le getter à la température normalement requise par les getters habituels puisqu'il n'y a nul besoin d'activation du getter à hydrogène réalisé dans un matériau insensible à la passivation.

Une forme alternative de mise en œuvre de l'invention dans le cas de boitiers scellés collectivement est d'utiliser un élément getter sous forme de lame getter telle que décrit précédemment. Cette lame est ainsi fabriquée selon le principe de l'invention en déposant une couche de matériau de piégeage de l'hydrogène, notamment une couche de palladium sur un support minéral (typiquement en métal ou céramique), et la lame est intégrée par brasage sans flux dans l'enceinte hermétique soit avant, par exemple concurremment à l'étape de fixation du composant microélectronique, soit pendant le cycle de scellement final de la fenêtre sur les parois du boitier. Dans ce cas la fenêtre peut être une fenêtre selon l'état de la technique, ou une fenêtre selon l'invention sur laquelle le matériau getter joue également le rôle de matériau d'interface de brasure tel que cela est décrit précédemment.

### C) TROISIEME EXEMPLE : SCELLEMENT COLLECTIF SELON L'APPROCHE DITE « WAFER LEVEL PACKAGING »

L'invention s'applique également au scellement des composants notamment bolométriques à l'échelle de substrats selon la technique dite « *wafer level packaging* ».

Selon l'état de la technique, illustré en référence avec la vue en coupe schématique de la figure 3, un premier substrat transparent **40,** dit « wafer fenêtre » ou « wafer capot », sur lequel des cavités **42** ont été réalisées, est assemblé par brasage, thermocompression ou fusion sous vide, à un second substrat **44,** dit « wafer puce », qui porte une pluralité de puces micro électroniques **46** comportant chacune par exemple en surface une rétine sensible, chaque cavité **42** venant recouvrir une des puces **46.** Ces composants réalisés collectivement comprennent également dans chaque cavité **42** un getter **50** pour obtenir un vide poussé de manière à assurer leur performance maximale.

La nature de l'interface de brasage assurant l'herméticité de l'assemblage des composants de type « *wafer level packaging* » est généralement différente de celle des composants réalisés unitairement : les états de surface et les planéités des wafers capots et des wafers puces permettent en effet de réduire de manière importante les quantités de brasure utilisées par rapport à des assemblages réalisés unitairement sur des boîtiers séparés.

Ainsi, les faibles épaisseurs de brasure requises autorisent le dépôt des couches métalliques de brasure directement sur le wafer capot ou/et sur le wafer puce. La méthode de dépôt est généralement électrolytique et/ou physique, par exemple par pulvérisation cathodique (« *sputtering* ») ou évaporation. Pour la réalisation des métallisations de brasage, une technique consiste à déposer d'abord par des procédés physiques (« *sputtering* » ou évaporation), selon des épaisseurs très fines, une couche de nucléation **52** (ou « *seed layer* ») sur les surfaces réservées à l'interface de scellement, formée d'une couche d'accroche et d'une couche de métal noble. Le métal noble permet d'éviter la passivation à l'air des surfaces métalliques, de manière à assurer la qualité des interfaces et du recouvrement des surfaces exposées dans une seconde étape de croissance électrolytique, destinée au dépôt sélectif localisé aux surfaces exposées, du matériau de brasure **54** proprement dit sur une épaisseur plus élevée. Le dépôt sélectif permet de limiter la consommation de métaux précieux, tels que l'or, constituant usuel du matériau de brasure.

Habituellement, la couche d'accroche est réalisée en titane ou en chrome et présente une épaisseur comprise entre 30 nm et 300nm, et la couche de matériau de brasure, par exemple en or, présente une épaisseur comprise entre 100 nm et 500 nm. Ces couches sont définies soit par gravure, soit par masquage ou moyen d'une technique de « *lift-off »* ou de pochoir « *shadow mask* ». La couche électrolytique par exemple est formée d'or sur une épaisseur comprise entre 1 µm et 5 µm, puis d'étain sur une épaisseur comprise entre 1 µm et 5 µm. Lors du procédé de scellement par thermocompression sous vide l'or et l'étain inter-diffusent puis fondent partiellement pour former un alliage au moins en partie eutectique.

Dans le cadre de l'invention, l'or de la couche de nucléation sur au moins un des substrats (wafer capot ou wafer puce) est remplacé par du palladium, qui est déposé sur une plus large surface d'un premier substrat de manière à former deux zones connexes ou disjointes. La première zone est destinée à former ou interfacer le joint de brasure en regard de la métallisation du second substrat, et la seconde zone en regard de l'intérieur de chaque cavité, qui reste libre après scellement, c'est-à-dire en interaction directe avec l'atmosphère de la cavité, est destinée à former le getter **50.**

Le scellement hermétique est évidemment réalisé comme décrit en relation avec les modes de réalisation précédents, c'est-à-dire par mise en œuvre d'un pompage pour le dégazage suivi d'un scellement sans flux, notamment un dégazage et un scellement réalisés dans le même cycle thermique sous vide poussé pour atteindre la pression finale requise dans le composant.

Dans le cas où il est préféré former les couches de brasure sur le substrat qui porte aussi le getter, afin d'éviter le dépôt électrolytique des couches de brasure sur les secondes zones, ces dernières sont préférentiellement masquées avant l'opération d'électrolyse par une résine photosensible définie par photolithographie. Ainsi, la zone non recouverte par le dépôt électrolytique est utilisée comme getter à hydrogène dans l'assemblage, sans qu'il soit besoin d'apporter cette fonction getter au moyen d'étapes additionnelles spécifiques nécessaires selon l'état de la technique. Il est ainsi réalisé une économie substantielle de temps, de moyens et de couts.

### D) QUATRIEME EXEMPLE : SCELLEMENT MONOLITHIQUE SUR WAFER SELON LA TECHNIQUE DE MICRO-ENCAPSULATION OU « PIXEL LEVEL PACKAGING »

Dans le cadre du scellement hermétique connu sous l'expression « *Pixel Level Packaging* » ou « *microcapping* », chaque pixel ou groupe de pixels d'une rétine bolométrique est encapsulé dans un boitier hermétique individuel (ou « *microcapsule* »), les boitiers étant réalisés collectivement au moyen de couches monolithiques obtenues par dépôt direct de type microélectronique sur un substrat puce. Le détail de divers modes de réalisation est fourni par exemple par le document US 6 753 526. Selon cet état de la technique, afin d'atteindre et maintenir le niveau de vide requis, un getter en couche mince est constitué par un dépôt localisé de titane dans chaque cavité hermétique ainsi définie. Dans le cas de l'utilisation d'un getter activable en température comme décrit ci-dessus, les solvants, résines et divers procédés agressifs, en particulier oxydants, utilisés lors de l'assemblage technologique des microstructures sensibles et de leurs cavités, altèrent la surface du getter, voire inhibent au moins partiellement ses propriétés de piégeage de molécules gazeuses. Il en résulte potentiellement la nécessité, après scellement des microcapsules, d'une activation thermique à relativement haute température pour régénérer ses propriétés.

Dans le cadre de l'invention, ce getter est substitué par un getter à hydrogène, préférentiellement constitué d'au moins deux couches :
- d'une part, une couche d'accroche, dont la fonction est de réaliser la cohésion mécanique entre le matériau du getter à hydrogène et le substrat sur lequel le getter est réalisé, et
- d'autre part une couche de métal noble, susceptible d'absorber de l'hydrogène par physisorption, notamment une couche de palladium.

Le scellement hermétique est évidemment réalisé comme décrit en relation avec les modes de réalisation précédents, c'est-à-dire par la mise en œuvre d'un pompage pour le dégazage suivi d'un scellement sans flux, notamment un dégazage et un scellement réalisés dans le même cycle thermique sous vide poussé pour atteindre la pression finale requise dans le composant.

Outre ces propriétés d'insensibilité à la passivation à l'atmosphère, l'intérêt du métal noble est qu'il résiste aux solvants et résines traditionnels utilisés pour la construction des microstructures et de leurs cavités sans altération de sa surface. Ce métal ne nécessite donc pas d'activation particulière et fonctionne comme dans les modes de réalisation précédents.

L'invention présente ainsi plusieurs avantages.

L'invention permet de déposer le getter à hydrogène et la métallisation pour le brasage sans flux lors de la même étape, ce qui permet d'économiser le prix et le temps d'un procédé complet de dépôt et structuration du getter. Le gain de coût apporté par l'invention est donc très substantiel.

En outre, les getters à base de titane ou à base de zirconium habituellement utilisés pour le scellement sous vide secondaire nécessitent de chauffer les composants à des températures nécessairement au-delà de 300°C, voire même plus efficacement au moins à 350°C. Le budget ou plage thermique subi par les composants microélectroniques à ces températures peut affecter les caractéristiques physiques des parties les plus sensibles intégrées dans le boitier (typiquement les microbolomètres dans l'exemple suivi) et donc leurs performances, voire leurs fonctionnalités. La méthode d'assemblage ainsi que le getter proposé par cette invention permettent de sceller les composants délicats à des températures inférieures à ce qu'impose l'état de la technique, du fait que la température maximale est imposée par la température de fusion de l'alliage utilisé pour le brasage sans flux, et non la nécessaire activation du getter. Or, pour les alliages traditionnels compatibles avec les brasures sans flux, la gamme de température de scellement des boitiers généralement dans la gamme de 150 °C (alliages riches en indium) à 250 °C (alliages riches en étain) est bien plus faible que les températures d'activation des getters classiques. La température maximale subie par les composants fragiles est ainsi nettement diminuée, et il en résulte une plus grande latitude de mise en œuvre de constructions sensibles moins résistantes que ce qu'exige l'état de la technique, alors que l'usage normal du composant après fabrication ne nécessite nullement ce niveau de résistance élevé. Des constructions sensibles plus performantes deviennent ainsi productibles grâce à l'invention sans autre complications.

Le palladium qui est proposé préférentiellement du fait de son coût accessible et ses caractéristique avantageuses, peut éventuellement être remplacé par du platine, (plus onéreux) comme précisé précédemment.

La température de brasage de la fenêtre est contrainte par le choix de l'alliage métallique de la brasure, et non plus par la température d'activation du getter, comme pour les assemblages généralement pratiqué dans l'état de l'art. En pratique, on se dirigera vers des brasures ayant des températures de fusion comprises entre 156 °C (Indium pur) et 280°C (Au80-Sn20) en fonction des caractéristiques recherchées pour l'assemblage.

Il a été décrit des modes de réalisation dans lesquels un brasage sans flux est mis en œuvre pour sceller la fenêtre sur l'embase du boitier. En variante, une liaison anodique, une liaison par diffusion métallique, ou une liaison par adhésion moléculaire est mise en œuvre pour sceller le boitier, une partie de la couche formant le getter participant ou non dans le scellement sans flux.

De même, il a été décrit un getter sous la forme d'une couche mince métallique, e.g. d'épaisseur inférieure au micromètre, cette forme de réalisation étant notamment privilégiée lorsque ladite couche est utilisée pour le scellement du boitier. En variante, le getter peut comprendre une couche de matériau de piégeage de l'hydrogène d'épaisseur plus importante, qu'une partie de cette couche formant le getter participe ou non au scellement sans flux. Par exemple, la couche de matériau de piégeage peut avoir une épaisseur de plusieurs micromètres.

De même, il a été décrit une application privilégiée de l'invention à l'encapsulation de détecteur bolométrique pour la détection infrarouge, e.g. dans la gamme LWIR. L'invention s'applique bien entendu à tout type de composant microélectronique nécessitant une telle encapsulation, notamment un composant microélectromécanique (MEMS) ou micro-optoélectromécanique (MOEMS).

## Revendications

1. Procédé de fabrication d'un dispositif comprenant un composant microélectronique (16 ; 46) et un boitier (24 ; 40, 44), le composant microélectronique étant logé dans le boitier, ledit boitier étant formé de parois délimitant un volume interne (22 ; 42) hermétique sous vide, ledit dispositif étant constitué de matériaux susceptibles de dégazer dans ledit volume interne (22 ; 42), lesdits matériaux étant des matériaux métalliques, céramiques ou semi-conducteurs inorganiques, ou du carbone, ou toute combinaison, assemblage, alliage, dispersion desdits matériaux entre eux, le procédé comprenant :
- la réalisation d'un piège à gaz (36 ; 50) sous forme de couches minces apte à piéger du gaz dans ledit volume interne, et uniquement de l'hydrogène, le piège à gaz étant inerte vis-à-vis de l'oxygène et/ou de l'azote ;
- le pompage dudit volume interne (22 ; 42) ;
et dans lequel :
- pendant le pompage, le chauffage du dispositif est réalisé de manière à dégazer des éléments logés dans ledit volume interne (22 ; 42) ;
- après ledit pompage, le scellement hermétique du boitier (24 ; 40, 44) est réalisé sans utiliser de flux au moyen d'une brasure sans flux, d'une liaison anodique, d'une liaison par diffusion métallique ou d'une liaison par adhésion moléculaire ; et
- le chauffage du dispositif et le scellement du boitier sont réalisés à une température inférieure à 300 °C.

2. Procédé selon la revendication 1, ***caractérisé* en ce que** :
- la réalisation du boitier (24) comporte la réalisation de parois inférieures (10) et d'un capot supérieur (18) ;
- la réalisation du piège à gaz comporte la réalisation d'une couche métallique (36) de matériau de piégeage de l'hydrogène sur le capot (18) ;
- le report du capot (18) sur les parois inférieures (10) avec une première partie (34) uniquement de ladite couche (34, 36) métallique de matériau de piégeage reposant sur les parois inférieures (10) ;
- la réalisation du piège à gaz avec au moins une seconde partie (36) de ladite couche de piégeage ne reposant pas sur les parois inférieures (10) ; et
- l'application d'une action mécanique sur et/ou un chauffage de ladite première partie (34) de la couche métallique de matériau de piégeage de manière à former un joint métallique hermétique entre le capot (18) et les parois inférieures (10).

3. Procédé selon la revendication 2, ***caractérisé* en ce que** la première partie (34) et la au moins seconde partie (36) de ladite couche métallique de matériau de piégeage sont connexes ou disjointes.

4. Procédé selon l'une quelconque des revendications précédentes, ***caractérisé* en ce que** le piège à gaz comporte un matériau de piégeage de l'hydrogène constitué de palladium ou de platine.

5. Procédé selon la revendication 4, ***caractérisé* en ce que** le piège à gaz comprend une couche de palladium ou de platine d'une épaisseur comprise entre 100 nanomètres et 1 micromètre.

6. Procédé selon l'une quelconque des revendications précédentes, ***caractérisé* en ce que** la pression de gaz dans le volume interne (22 ; 42) est inférieure à 10⁻⁴ mbar, et **en ce que** le composant électronique (16 ; 46) est un détecteur bolométrique.

7. Dispositif comprenant un composant microélectronique (16 ; 46) et un boitier (24 ; 40, 44), le composant microélectronique étant logé dans le boitier, obtenu selon le procédé de l'une quelconques des revendications 1 à 6, dans lequel :
- le boitier (24 ; 40, 44) est formé de parois délimitant un volume interne hermétique sous vide (22 ; 42),
- le dispositif est constitué de matériaux susceptibles de dégazer dans ledit volume interne (22 ; 42), lesdits matériaux étant des matériaux métalliques, céramiques ou semi-conducteurs inorganiques, ou du carbone, ou toute combinaison, assemblage, alliage, dispersion desdits matériaux entre eux ;
- un piège à gaz (36 ; 50) est logé dans le volume interne (22 ; 42), et piège uniquement de l'hydrogène et est inerte vis-à-vis de l'oxygène et/ou de l'azote.

8. Dispositif selon la revendication 7, ***caractérisé* en ce que** le piège à gaz (36 ; 50) est constitué d'un empilement de deux couches, respectivement une couche d'accroche réalisée en titane ou en chrome sur laquelle est déposée une couche de matériau de piégeage.

9. Dispositif selon la revendication 8, ***caractérisé* en ce que** la couche de matériau de piégeage du piège à gaz (36, 50) est constituée par du palladium ou du platine pour piéger l'hydrogène.

10. Dispositif selon l'une des revendications 8 et 9, ***caractérisé* en ce que** l'épaisseur des couches d'accroche et de piégeage est respectivement comprise entre 30 et 300 nanomètres, et entre 100 nm et 1 micromètre.

11. Dispositif selon l'une des revendications 8 à 10, ***caractérisé* en ce que** le composant microélectronique (46) comporte au moins une membrane bolométrique suspendue au-dessus d'un substrat.

12. Dispositif selon l'une des revendications 8 à 11, comportant un boitier comprenant une fenêtre scellée hermétiquement sur une embase au moyen d'une couche métallique de scellement, et un piège à gaz comprenant une couche de matériau métallique de piégeage, ***caractérisé* en ce que** la couche de scellement et la couche de matériau de piégeage sont constituées d'une même et unique couche de matériau métallique.

## Patentansprüche

1. Verfahren zur Herstellung einer Vorrichtung mit einem mikroelektronischen Bauelement (16; 46) und einem Gehäuse (24; 40, 44), das mikroelektronische Bauelement ist dabei im Gehäuse untergebracht, dieses Gehäuse besteht aus Wänden, die einen hermetisch abgedichteten Vakuuminnenraum (22; 42) umschließen, diese Vorrichtung besteht aus Materialien, die in diesem Innenraum (22; 42) entgasen, bei diesen Materialien handelt es sich um metallische oder keramische Materialien, anorganische Halbleiter oder Kohlenstoff oder alle Kombinationen, Verbindungen, Legierungen, Dispersionen aus diesen Materialien, wobei das Verfahren umfasst:
- Herstellung eines Getters (36; 50) in Form dünner Schichten, die in der Lage sind, Gas in diesem Innenraum einzufangen, und zwar nur Wasserstoff, da der Getter inert ist gegenüber Sauerstoff und/ oder Stickstoff,
- Auspumpen dieses Innenraums (22; 42);
und bei dem:
- während des Auspumpens die Beheizung der Vorrichtung in einer Art und Weise erfolgt, dass in diesem Innenraum (22; 42) untergebrachte Elemente entgast werden;
- nach diesem Auspumpen erfolgt die hermetische Abdichtung des Gehäuses (24; 40, 44) ohne Einsatz von Flussmitteln, mittels einer flussmittelfreien Lötung, einer anodischen Verbindung, einer Verbindung durch Metalldiffusion oder einer Verbindung durch molekulare Haftung; und
- die Heizung der Vorrichtung sowie die Abdichtung des Gehäuses erfolgen bei einer Temperatur von unter 300 °C.

2. Verfahren nach Anspruch 1, ***dadurch gekennzeichnet, dass*** :
- die Herstellung des Gehäuses (24) die Herstellung der unteren Wände (10) und einer oberen Haube (18) beinhaltet;
- die Herstellung des Getters die Herstellung einer Metallschicht (36) aus Gettermaterial für Wasserstoff auf der Haube (18) umfasst;
- das Aufsetzen der Haube (18) auf den unteren Wänden (10) wobei nur ein erster Teil (34) dieser metallischen Gettermaterialschicht (34, 36) auf den unteren Wänden aufliegt (10);
- die Herstellung des Getters mit mindestens einem zweiten Teil (36) dieser Getterschicht, der nicht auf den unteren Wänden (10) aufliegt; und
- die Anwendung einer mechanischen Aktion an und/ oder eine Erwärmung dieses ersten Teils (34) der metallischen Gettermaterialschicht um eine hermetische, metallische Abdichtung zwischen der Haube (18) und den unteren Wänden (10) zu bilden.

3. Verfahren nach Anspruch 2, ***dadurch gekennzeichnet, dass*** der erste Teil (34) und der mindestens zweite Teil (36) dieser metallischen Gettermaterialschicht verbunden oder getrennt sind.

4. Verfahren nach einem der vorangehenden Ansprüche, ***dadurch gekennzeichnet, dass*** der Getter ein Wasserstoff-Gettermaterial enthält, das aus Palladium oder Platin besteht.

5. Verfahren nach Anspruch 4, ***dadurch gekennzeichnet, dass*** der Getter eine Palladium- oder Platinschicht mit einer Dicke zwischen 100 Nanometern und 1 Mikrometer enthält.

6. Verfahren nach einem der vorangehenden Ansprüche, ***dadurch gekennzeichnet, dass*** der Gasdruck im Innenraum (22; 42) unter 10⁻⁴ mbar liegt, und dass das mikroelektronische Bauelement (16; 46) ein bolometrischer Detektor ist.

7. Vorrichtung mit einem mikroelektronischen Bauelement (16; 46) und einem Gehäuse (24; 40, 44), wobei das mikroelektronische Bauelement im Gehäuse untergebracht ist, die nach dem Verfahren eines der Ansprüche 1 bis 6 hergestellt wird, in der:
- das Gehäuse (24; 40, 44) aus Wänden gebildet wird, die einen hermetisch abgedichteten Vakuuminnenraum (22; 42) begrenzen;
- die Vorrichtung aus Materialien besteht, die in diesem Innenraum (22; 42) entgasen können, wobei es sich bei diesen Materialien um metallische oder keramische Materialien, anorganische Halbleiter oder Kohlenstoff, oder alle Kombinationen, Verbindungen, Legierungen, Dispersionen aus diesen Materialien handelt;
- ein Getter (36; 50) im Innenraum (22; 42) untergebracht ist und nur Wasserstoff einfängt und gegenüber Sauerstoff und/oder Stickstoff inert ist.

8. Vorrichtung nach Anspruch 7, ***dadurch gekennzeichnet, dass*** der Getter (36; 50) aus zwei aufeinandergestapelten Schichten besteht, und zwar jeweils eine Haftschicht aus Titan oder Chrom auf der eine Gettermaterialschicht aufgebracht ist.

9. Vorrichtung nach Anspruch 8, ***dadurch gekennzeichnet, dass*** die Gettermaterialschicht des Getters (36, 50) aus Palladium oder Platin besteht, um Wasserstoff einzufangen.

10. Vorrichtung nach einem der Ansprüche 8 und 9, ***dadurch gekennzeichnet, dass*** die Dicke der Haft- und der Gettermaterialschicht jeweils zwischen 30 und 300 Nanometern und zwischen 100 nm und 1 Mikrometer liegt.

11. Vorrichtung nach einem der Ansprüche 8 bis 10, ***dadurch gekennzeichnet, dass*** das mikroelektronische Bauelement (46) mindestens eine bolometrische Membran enthält, die über einem Substrat aufgehängt ist.

12. Vorrichtung nach einem der Ansprüche 8 bis 11, mit einem Gehäuse, das ein Fenster enthält, das hermetisch dicht auf einer Fußplatte befestigt ist, mittels einer metallischen Abdichtschicht und mit einem Getter mit einer metallischen Gettermaterialschicht, ***dadurch gekennzeichnet, dass*** die Abdichtschicht und die Gettermaterialschicht aus ein und derselben einzigen metallischen Materialschicht bestehen.

## Claims

1. A method of manufacturing a device comprising a microelectronic component (16; 46) and a housing (24 ; 40, 44), the microelectronic component being housed in the housing, said housing being formed of walls defining a hermetically sealed vacuum inner space (22; 42), said device being constituted of materials likely to degas into the inner space (22 ; 42), said materials being metallic, ceramic, or inorganic semiconductor material, carbon, or any combination, assembly, alloy, dispersion of said materials between one another, the method comprising:
- forming a getter (36; 50) in the form of thin films capable of trapping gas in said inner space, and only hydrogen, the getter being inert to oxygen and/or nitrogen ;
- pumping from said inner space (22; 42);
in which :
- during pumping, heating the device to degas the elements housed in said inner space (22; 42); and
- after said pumping, hermetically sealing the housing (24; 40, 44) in fluxless fashion by means of a fluxless soldering, of an anodic bonding, of a bonding by metal diffusion, or of a molecular bonding ; and
- the heating of the device and the sealing of the housing are carried out at a temperature lower than 300°C.

2. The method of claim 1, ***characterized* in that**:
- the forming of the housing (24) comprises forming lower walls (10) and an upper cap (18);
- the forming of the getter comprises forming a metal layer (36) of hydrogen getter material on the cap (18);
- the placing of the cap (18) on the lower walls (10) with a first portion (34) only of said metallic getter material layer (34, 36) resting on the lower walls (10);
- the forming of the getter with at least a second portion (36) of said getter layer which does not rest on the lower walls (10); and
- the application of a mechanical action on and/or a heating of said first portion (34) of the metallic getter material layer to form a hermetic metal seal between the cap (18) and the lower walls (10).

3. The method of claim 2, ***characterized* in that** the first portion (34) and the at least one second portion (36) of said metallic getter material layer are adjacent or separate.

4. The method of any of the foregoing claims, ***characterized* in that** the getter comprises a hydrogen getter material made of palladium or of platinum.

5. The method of claim 4, ***characterized* in that** the getter comprises a palladium or platinum layer having a thickness in the range from 100 nanometers to 1 micrometer.

6. The method of any of the foregoing claims, ***characterized* in that** the gas pressure in the inner space (22; 24) is smaller than 10⁻⁴ mbar, and **in that** the electronic component (16; 46) is a bolometric detector.

7. A device comprising a microelectronic component (16; 46) and a housing (24 ; 40, 44), the microelectronic component being housed in the housing obtained according the method of any one of claims 1 to 6, in which :
- the housing (24; 40, 44) is formed of walls defining a hermetically sealed vacuum inner space (22; 42);
- the device is constituted of materials likely to degas into the inner space (22 ; 42), said materials being metallic, ceramic, or inorganic semiconductor material, carbon, or any combination, assembly, alloy, dispersion of said materials between one another,:
- a getter (36; 50) is housed in the inner space (22; 42) and only traps hydrogen and is inert to oxygen and/or nitrogen.

8. The device of claim 7, ***characterized* in that** the getter (36; 50) is constituted of a stack of two layers, respectively a bonding layer made of titanium or chromium bonding layer, above which is deposited a getter layer.

9. The device of claim 8, ***characterized* in that** the getter layer (36; 50) is constituted of palladium or platinum to trap hydrogen.

10. The device of any of claims 8 and 9, ***characterized* in that** the thickness of the bounding layer and of the getter layer is respectively between 30 and 300 nm and between 100 nm and 1 micrometer.

11. The device of any of claims 8 to 10, ***characterized* in that** the microelectronic component (46) comprises at least one bolometric membrane suspended above a substrate.

12. The device of any of claims 8 to 11, comprising a housing provided with a window hermetically sealed onto a base by means of a metallic sealing layer, and a getter comprising a metallic getter material layer, ***characterized* in that** the sealing layer and the getter material layer are formed of one and the same layer of metallic material.
